# EUROPEAN PATENT APPLICATION

(11) **EP 2 113 524 A1**
(43) Date of publication of application: **04.11.2009**
(21) Application number: 08720788.2
(22) Date of filing: 21.02.2008
(51) Int. Cl.: C08G 59/62, B32B 15/092, C08J 5/24, C08K 3/22, C08K 3/36, C08L 63/00, H05K 1/03

(54) **EPOXY RESIN COMPOSITION, PREPREG, LAMINATES AND PRINTED WIRING BOARDS**

(30) Priority: 23.02.2007 JP 2007044658; 28.08.2007 JP 2007221775
(71) Applicant: Panasonic Electric Works Co., Ltd, Kadoma-shi Osaka 571-8686 (JP)
(72) Inventor: FUJINO, Kentaro, Kadoma-shi Osaka 571-8686 (JP); SAWADA, Tomoaki, Kadoma-shi Osaka 571-8686 (JP); NISHINO, Mitsuyoshi, Kadoma-shi Osaka 571-8686 (JP); SHINPO, Takashi, Kadoma-shi Osaka 571-8686 (JP); NAKAMURA, Yoshihiko, Kadoma-shi Osaka 571-8686 (JP); YAMAGUCHI, Mao, Kadoma-shi Osaka 571-8686 (JP)
(74) Representative: Appelt, Christian W.
(86) International application number: PCT/JP2008/052996
(87) International publication number: WO 2008/102853

(57) **Abstract**

The present invention provides an improved epoxy resin composition enabling better dimensional stability of a laminate by decreasing the coefficient of thermal expansion in its thickness direction of a laminate manufactured using an epoxy resin composition as a material, and by retaining a high level of adhesion in the cured product thereof, enabling better drilling workability of the laminate and suppression of crack development therein during the drilling process, and enabling to decrease impregnation of the plating solution into the laminate associated with those cracks.

This epoxy resin composition includes:
(A) an epoxy resin;
(B) a curing agent composed of phenolic novolac resin curing agent or amine curing agent,
(C) an inorganic filler composed of aluminum hydroxide with or without spherical silica; and
(D) an elastic component made of minute particles having a core-shell structure with its shell constituted by a resin which is compatible with said epoxy resin (A).

The epoxy resin composition exhibits, when cured into an article, a linear coefficient (a_{z}) of thermal expansion of 48 or less with respect to a thickness of said article.

## Description

### TECHNICAL FIELD

The present invention relates to an epoxy resin composition, a prepreg manufactured using this epoxy resin composition, a laminate manufactured using this prepreg, and a printed wiring board manufactured using this laminate.

### BACKGROUND ART

Thermosetting resins typified by epoxy resins are widely used as printed wiring board material and semiconductor sealing material because they provide excellent adhesive properties, electrical insulation properties, resistance to chemicals, and the like. During the process of manufacturing a printed wiring board, a resin varnish comprising the aforementioned thermosetting resin is used to impregnate a substrate such as glass cloth and the like to manufacture a prepreg. After this prepreg is stacked in a predetermined number of layers, and metal foil is stacked and aligned therewith, and forming with a hot press is carried out to manufacture a laminate. Then a printed wiring board is manufactured by fabricating a conductive pattern in the metal foil on the surface of the laminate to form a circuit.

Recently, higher densification of printed wiring boards has rapidly progressed. The use of a laminate with little dimensional change is desired for the high yield manufacturing of a printed wiring board whereupon a high density, fine conductive pattern is formed. Furthermore, depending on the installation environment, the printed wiring board may be exposed to high temperatures, and thermal expansion in the planar direction can occur. At that time, if components are mounted on the surface of the printed wiring board by soldered junctions, cracks can occur in the solder and connection failures can result. Therefore, the coefficient of thermal expansion in the planar direction of a laminate must be kept low.

Furthermore, a printed wiring board sometimes has interlayer through-holes. In such a case, a failure of conductivity between the layers can occur if the coefficient of thermal expansion in the direction of thickness of the laminate is too great. Therefore, control of the coefficient of thermal expansion in the direction of thickness of a laminate is also necessary.

Epoxy resin compositions that contain fine particles with a core-shell structure to increase impact and heat resistance in a laminate, and flexible printed wiring boards are already known (see, for example, Japanese Unexamined Patent Application Publication No. 2001-123044, 2002-338875, and 2003-213082).

In addition, resin varnishes comprising an epoxy resin and containing fine particles with the kind of core-shell structure noted above to reduce the coefficient of thermal expansion of a laminate are known, as well as ones containing rubber particles with a core-shell structure and covered by a shell layer that is compatible with an epoxy resin (see, for example, Japanese Unexamined Patent Application Publication No.1996-48001, 2000-158589, and 2003-246849) or ones containing fine particles with rubbery elasticity that are not compatible with an epoxy resin (see, for example Japanese Patent No. 3173332).

However, although it is possible to reduce the coefficient of thermal expansion in the planar direction of a laminate by such means, reducing the coefficient of thermal expansion in the direction of thickness of a laminate has not reached a satisfactory level. Therefore, a greater reduction in the coefficient of thermal expansion in the direction of thickness in a laminate is needed.

The present applicants have already developed an improved epoxy resin composition (see Japanese Unexamined Patent Application Publication No.2006-143973). When this epoxy resin composition is used in the manufacture of a laminate, not only is the coefficient of thermal expansion in the planar direction of the laminate reduced, but the coefficient of thermal expansion in the direction of thickness is also reduced. This epoxy resin composition comprises an epoxy resin, a curing agent, and an elastic component. The aforementioned curing agent is a phenol-novolac resin, and the aforementioned elastic component is fine particles having a core-shell structure wherein the shell member is formed from a resin compatible with an epoxy resin.

In the epoxy resin composition disclosed in Japanese Unexamined Patent Application Publication No. 2006-143973 the curing agent is a phenol-novolac resin and the elastic component is fine particles having a core-shell structure wherein the shell member is formed from a resin compatible with an epoxy resin. Therefore, the coefficient of thermal expansion both in the planar direction and in the direction of thickness is reduced, and dimensional changes are also reduced in a laminate manufactured using this epoxy resin composition. As a result, when this laminate is used for the manufacture of a printed wiring board, that printed wiring board can be produced with a good yield, and it also has excellent properties.

Thereafter, the inventors continued their investigation of the aforementioned improved epoxy resin composition even further, believing that the properties of this epoxy resin composition could be improved even more while retaining the aforementioned element (i.e., decreased coefficient of thermal expansion in the direction of thickness of the laminate) of that improved epoxy resin composition. Incorporating an inorganic filler in an epoxy resin composition is effective for reducing the coefficient of thermal expansion in the direction of thickness and for increasing heat resistance and the like in a laminate, but in such a case the following problems occur.

The first problem that can be noted is when the content of inorganic filler is too large, workability in the drilling process becomes poor in a laminate manufactured using an epoxy resin. Because the aforementioned drilling process is performed for the purpose of forming through-holes and the like, it is carried out using a drill bit, but as a result, inorganic filler markedly increases wear on the drill bits used in drilling process.

The second problem that can be noted is that when an inorganic filler is incorporated therein, the adhesion in the cured product of the epoxy resin composition is decreased. In such a case, cracks develop in the laminate during the aforementioned drilling process, and in the subsequent circuit forming process that includes an etching treatment, impregnation of the plating solution into the laminate can occur through the inside walls of the holes. The yield during the production of the printed wiring board is reduced as a result.

### DISCLOSURE OF THE INVENTION

With the foregoing in view, the present invention was created based on knowledge gained by the applicants in the development process so far. In other words, the present invention addresses the problem of providing a new and improved epoxy resin composition for a laminate manufactured using an epoxy resin composition as a material therefor. This new and improved resin composition enables better dimensional stability of the laminate by decreasing the coefficient of thermal expansion not only in its planar direction, but also in its thickness direction, and by retaining a high level of adhesion in the cured product thereof, better drilling workability of the laminate and suppression of crack development in the laminate during the drilling process, and enables the decrease in impregnation of the plating solution into the laminate associated with those cracks. In addition, the present invention addresses the problem of providing a prepreg, a laminate, and a printed wiring board that are manufactured using this epoxy resin composition.

An epoxy resin composition of the present invention is an epoxy resin composition including:
(A) an epoxy resin;
(B) a curing agent composed of phenolic novolac resin curing agent or amine curing agent,
(C) an inorganic filler composed of aluminum hydroxide with or without spherical silica; and
(D) an elastic component made of minute particles having a core-shell structure with its shell constituted by a resin which is compatible with the epoxy resin (A),
wherein the epoxy resin composition exhibits, when cured into an article, a linear coefficient (a_{z}) of thermal expansion of 48 or less with respect to a thickness of the article.

The aforementioned cured state refers to a state wherein the cured product of the epoxy resin composition forms a dielectric layer in the laminate when a laminate is manufactured using the epoxy resin composition of the present invention. The direction of the thickness (Z) refers to the thickness direction of the laminate. The coefficient of thermal expansion (α_{z}) is the coefficient of linear expansion (α_{z}) of the insulating layer formed of the cured product in the laminate.

The epoxy resin composition in the cured state in accordance with the present invention has the linear coefficient of thermal expansion (α_{z}) in the thickness direction (Z) of 48 or less, enabling to decrease the linear coefficient of thermal expansion in thickness directions of the laminate and printed circuit board manufactured using the epoxy resin composition, and increase the dimensional stability of the laminate and the printed circuit board. In combination therewith, the shock absorption of the cured product is increased, and as a result, the workability is improved when drilling the laminate made of the epoxy resin compotion with a drill bit. Furthermore, wear on the drill bit used during the drilling process is reduced. Because the epoxy resin composition contains the inorganic filler (C), the adhesion of the cured product of the epoxy resin composition is kept at a high level. As a result, adhesion between the cured product of the epoxy resin composition and a substrate such as glass cloth is kept at a high level in a laminate manufactured using the epoxy resin composition. Consequently, the development of cracks is suppressed when drilling the laminate with the drill bit. And as a result thereof, When making a circuit forming treatment involving the etching on the laminate, it is possible to suppress leaching of the plating solution into the laminate though a path along the inner walls of the holes formed in the laminate. Thus, the printed wiring board is produced with a good yield.

It is preferable that 7 to 40 parts by weight of the elastic component (D) is incorporated with respect to 100 parts by weight of total of the epoxy resin (A) and the curing agent (B), in this epoxy resin composition.

This specified content ratio of the elastic component (D) makes the aforementioned effect more certain and pronounced.

Furthermore, it is preferable that the elastic component (D) has a structure free from fusion between its primary particles, and the elastic component (D) has a structure with its primary particles being fused with each other, in this epoxy resin composition.

In such a case, the shock absorption of the cured product becomes more noteworthy because the elastic component (D) has a structure free from fusion between its primary particles. However, the shock absorption of the cured product becomes even more noteworthy when the elastic component has a structure with fusion between its primary particles.

Moreover, it is preferable that the curing agent (B) is phenolic novolac resin curing agent, and 60 or less parts by weight of the inorganic filler is incorporated with respect to 100 parts by weight of total of the epoxy resin (A) and the curing agent (B), in this epoxy resin composition. Moreover, it is preferable that curing agent (B) is phenolic novolac resin curing agent, and the inorganic filler (C) has 1 or less of a weight ratio of the spherical silica to aluminum hydroxide, in this epoxy resin composition. Additionally, it is preferable that the curing agent (B) is phenolic novolac resin curing agent, the epoxy resin (A) includes an epoxy resin (A1) which has an oxazolidone ring within its molecular structure, and an epoxy equivalent of 30 to 390 g/eq, a bromine content of 10 to 20 % by weight, in this epoxy resin composition.

In such a case, when the curing agent (B) is a phenolic novolac resin, the adhesion of the cured product will be maintained at a particularly high level.

It is also preferable that the curing agent (B) is dicyandiamide in this epoxy resin composition.

In such a case, the adhesion of the cured product is improved even more.

The present invention also provides a prepreg fabricated by impregnating a substrate with the epoxy resin composition and half-curing the same by heat-drying, a laminate fabricated by stacking a predetermined number of the prepregs of together with a metal foil, and heating and pressing the same to form a printed wiring board having a conductor pattern on the metal foil of the laminate.

The prepreg of the present invention enables to decrease the coefficient of thermal expansion in thickness directions of the laminate and printed wiring board made of this prepreg, and increase the dimensional stability of the laminate and printed wiring board. Furthermore, the workability is improved when drilling a laminate made of this prepreg with a drill bit. The wear on the drill bit used during the drilling process is also reduced. The development of cracks is also reduced when drilling laminate of this prepreg with a drill bit. As a result, when making a circuit forming treatment involving the etching on the laminate, it is possible to suppress leaching of the plating solution into the laminate though a path along the inner walls of the holes formed in the laminate. Therefore, the printed wiring board is manufactured with a good yield.

The laminate of the present invention decreases the coefficient of thermal expansion in thickness directions of the laminate and of a printed wiring board made of this laminate, and increases the dimensional stability of the laminate and printed wiring board. Furthermore, the workability is improved when drilling laminate with a drill bit. The wear on the drill bit used during the drilling process is also reduced. The development of cracks is also suppressed when drilling laminate with a drill bit. As a result, when making a circuit forming treatment involving the etching on the laminate, it is possible to suppress leaching of the plating solution into the laminate though a path along the inner walls of the holes formed in the laminate. As a result, the printed wiring board is manufactured with a good yield.

The printed wiring board of the present invention decreases the coefficient of thermal expansion of the printed wiring board, and increases the dimensional stability of the printed wiring board. Furthermore, the workability is improved when drilling laminate with a drill bit during the manufacture of this printed wiring board. Wear on the drill bit used in the drilling process is also reduced. The development of cracks is also reduced when drilling laminate with a drill bit. As a result, when making a circuit forming treatment involving the etching on the laminate, it is possible to suppress leaching of the plating solution into the laminate though a path along the inner walls of the holes formed in the laminate. As a result, the printed wiring board is manufactured with a good yield.

### BEST MODE FOR CARRYING OUT THE INVENTION

Hereafter, the best mode for carrying out the invention is explained.

An epoxy resin composition of the present invention contains an epoxy resin (A), a curing agent (B), an inorganic filler (C), and an elastic component (D).

The curing agent (B) contains phenolic novolac resin curing agent or amine curing agent. The inorganic filler (C) comprises at least one of either spherical silica or aluminum hydroxide. The elastic component (D) contains minute particles having a core-shell structure with its shell formed from a resin which is compatible with the epoxy resin.

A linear coefficient (α_{z}) of thermal expansion in the thickness direction (Z) of the cured product of this epoxy resin composition is 48 or less. In particular, it is preferable for the coefficient (α_{z}) of thermal expansion to be 46 or less.

In this case, the coefficient of thermal expansion of the cured product of the epoxy resin composition is reduced because the epoxy resin composition comprises the above inorganic filler (C) and elastic component (D). The coefficient (α_{z}) of thermal expansion can be controlled by the amounts of inorganic filler (C) and elastic component (D) in the epoxy resin composition.

The aforementioned effect of the present invention is exhibited when the curing agent (B) is the phenolic novolac resin curing agent or the amine curing agent. When an amine curing agent is used as the curing agent (B), the cured product of the epoxy resin composition exhibits high adhesion, further suppressing the development of cracks in the laminate.

The epoxy resin (A) may be one having 2 or more epoxy groups per molecule thereof, such as bisphenol-A epoxy resin, bisphenol-F epoxy resin, bisphenol-S epoxy resin, biphenyl epoxy resin, alicyclic epoxy resin, polyfunctional phenol-diglycidyl ether compound, polyfunctional alcohol-diglycidyl ether compound, phenol-novolac resin composed of phenol-formaldehyde polycondensate glycidyl ether; cresol-novolac epoxy resin; bisphenol-A novolac epoxy resins, or halogenated compounds of the above-listed epoxy resins with high flame retardancy. The above-listed epoxy resins may be used either alone or in combination as the epoxy resin.

The content ratio of epoxy resin (A) based on the total weight of the epoxy resin composition is preferably within the range of 20 to 80 wt%, and more preferably, 30 to 70 wt%.

Furthermore, it is preferable that the epoxy resin (A) includes an epoxy resin (A1) which has an oxazolidine ring within its molecular structure, and an epoxy equivalent of 330 to 390 g/eq, and a bromine content of 10 to 20 wt%. The adhesion of the cured epoxy resin composition is improved by the use of epoxy resin (A1), and further improved by the use of a phenolic novolac resin as curing agent (B).

The epoxy resin (A1) may have the oxazolidine ring formulated as follows and a bromine atom, as a preferable example.

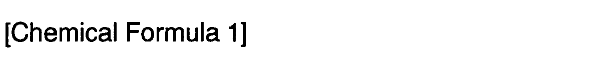

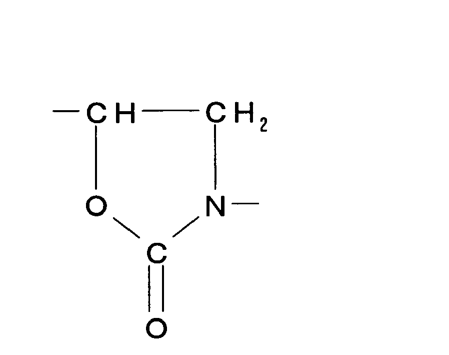

More specifically, the epoxy resin (A1) may be a resin having the following formula, as an example.

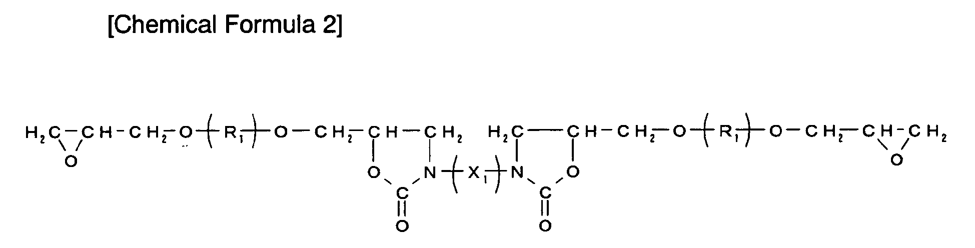

(wherein R₁ represents a divalent hydrocarbon group having a bromine atom and an aromatic ring, and X₁ represents a divalent hydrocarbon or derivative thereof.) When the epoxy resin (A1) contains bromine atoms in the range of 10 to 20 wt% as mentioned above, the cured product of the epoxy resin composition exhibits high flame retardancy.

Especially, when the number of individual epoxy groups per molecule in the epoxy resin (A1) is within the range of 1.9 to 2.9, a prepreg formed of the epoxy resin composition exhibits high toughness as well as high adhesion of the cured product.

For example, the epoxy resin (A1) may be "AER41 00", "AER5200" (available from Asahi Kasei Corporation), or "DER593" (available from The Dow Chemical Company).

It is preferable that at least 20 wt% of the epoxy resin (A1) is incorporated based on total weight of the epoxy resin (A) in the epoxy resin composition. More preferably, the epoxy resin (A1) content is in the range of 40 to 80 wt% for giving the cured product with high heat resistance and adhesion.

When the curing agent (B) is the phenolic novolac resin curing agent, a phenolic novolac resin is used as curing agent (B) in a suitable amount. For example, the phenolic novolac resin may be phenol-novolac resin, cresol-novolac resin, bisphenol novolac A resin, biphenyl-novolac resin, naphthol-aralkyl resin, or the like. These above-listed phenolic novolac resins may be used either alone or in combination as the phenolic novolac resin curing agent.

The curing agent (B) may be the amine curing agent, which is suitably selected among dicyandiamide, diaminodiphenylmethane, and the like. The use of dicyandiamide is especially preferred for giving the cured product with high adhesion.

An equivalent ratio of the curing agent (B) in the composition is preferably 0.4 to 1.5, more preferably 0.8 to 1.2, based on that of epoxy resin (A) for being free from insufficient curing of the epoxy resin composition and unreacted curing agent (B), such that a resultant laminate has a high heat resistance, shock resistance and the like.

The epoxy resin composition can also contain a curing accelerator to accelerate the curing reaction, such as imidazoles (e.g., 2-methyl imidazole, 2-phenyl imidazole, and imidazole silane), tertiary amines (e.g., triethylene diamine), and organic phosphines (e.g., triphenyl phosphine). The above-listed compounds may be used either alone or in combination as the curing accelerator. The amount of curing accelerator in the epoxy resin composition is preferably in the range of 0.03 to 5.0 wt%, based on the total resin component (total amount of the epoxy resin (A) and the curing agent (B)) in the epoxy resin composition.

The inorganic filler (C) comprises aluminum hydroxide as mentioned above, minimizing wear of drills due to the drilling process as well as retaining high adhesion of the cured product. The above effect is particularly enhanced when the inorganic filler (C) comprises both spherical silica and aluminum hydroxide. Preferably, the average particle size of the inorganic filler (C) is within the range of 0.3 to 5 µm. In such a case, the inorganic filler (C) act to sufficiently reduce the coefficient of thermal expansion of the cured product, and maintain excellent molding properties of the cured product.

The inorganic filler (C) can also comprise a different inorganic filler other than spherical silica and aluminum hydroxide, such as pulverized silica, magnesium hydroxide, glass powder, alumina, magnesium oxide, titanium dioxide, calcium carbonate, talc, and the like. The amount of the different inorganic filler is preferably 60 wt% or less, based on the total weight of the inorganic filler (C).

The content of the inorganic filler (C) in the epoxy resin composition is preferably within the range of 20 to 130 parts by weight based on 100 parts by weight of epoxy resin (A). The coefficient of thermal expansion of the cured product can be sufficiently regulated by control of the content of the inorganic filler (C) within the above range.

Particularly, when the content of the inorganic filler (C) in the epoxy resin composition is 60 or less parts by weight, based on 100 parts by weight of the total of the epoxy resin (A) and the curing agent (B), the adhesion of the cured product is retained at an even high level. The weight ratio of spherical silica to aluminum hydroxide in the inorganic filler (C) is preferably 1 or less. In such a case, the adhesion of the cured product is retained at an even higher level. These effects are particularly enhanced when the curing agent (B) is a phenolic novolac resin.

As mentioned above, the elastic component (D) in the epoxy resin composition comprises fine particles having a core-shell structure, with its shell formed from a resin which is compatible with the epoxy resin (A). A resin constituting the shell portion in this elastic component (D) may be PMMA (polymethyl methacrylate), polystyrene, or the like. Furthermore, it is preferable that a functional group reacting with epoxy resin (A) is introduced into the resin constituting the shell portion, such that the resin constituting the shell portion of this elastic component (D) is compatible with epoxy resin (A). In this case, epoxy resin (A) is compatible with the functional group by forming chemical bonding therebetween, regulating the thermodynamics of the elastic component (D) in the cured product, and thereby sufficiently minimizing the coefficient of thermal expansion of the cured product. The functional group acts to react with the epoxy resin by forming chemical bonding therebetween. As a preferred example, functional group may be a hydroxyl group, carboxyl group, or epoxy group. Preferably, at least one selected among these functional groups is introduced into the resin constituting the shell portion in the elastic component (D).

Furthermore, the material constituting the core portion in the elastic component (D) may be one selected among silicone resin, acrylic resin, butadiene rubber, isoprene rubber, and the like. Among the materials constituting the core portion, silicone resin and acrylic resin are preferred in consideration of the heat resistance thereof, and silicone resin is even more preferred in further consideration of the electrical properties thereof.

The content of the elastic component (D) of the epoxy resin composition is not particularly limited herein. The amount of the elastic component (D) in the epoxy resin composition is preferably within the range of 7 to 40 parts by weight with respect to 100 parts by weight of the total of the epoxy resin (A) and the curing agent (B) in the epoxy resin composition, for minimizing the coefficient of thermal expansion of the cured product and keeping high adhesion of the cured product.

When the amount of the elastic component (D) is 40 wt% or less as mentioned above, a resin varnish prepared from the epoxy resin composition exhibits reduced viscosity. The resin varnish can be uniformly impregnated into the substrate during manufacture of the prepreg, and thereby minimizing defects such as voids and thin spots during manufacture of the laminate.

The particle size of the elastic component (D) is preferably within the range of 0.1 to 10 µm. In this case, the elastic component (D) is uniformly dispersed in the epoxy resin composition. As a result, the coefficient of thermal expansion is kept further low.

Furthermore, an elastic component having a structure free from fusion between its primary particles can be used as the elastic component (D). When having high crosslinking density of the core portion in the elastic component (D), the elastic component (D) easily has the structure free from fusion between the primary particles. Additionally, an elastic component having a structure with fusion between the primary particles can be also used as the elastic component (D). When having low crosslinking density of the core portion in the elastic component (D), the elastic component (D) easily has the structure with fusion between the primary particles. In either of these case, the shock absorption of the cured product is increased. In the latter case, wherein the elastic component (D) has the structure with fusion between the primary particles, the aforementioned increase in shock absorption is further improved.

"Drilling Workability" is evaluated in terms of wear rate of a drill bit when drilling a hole in the laminate of the present invention in comparison with the reference laminate lacking the feature of the present invention, which is also explained in later with reference to Examples. The wear ratio is defined to be a ratio of a wear amount of the drill bit measured when drilling the lamination of the present invention to a wear amount of the drill bit measured when drilling the reference laminate. For example, the laminate giving a wear ratio of less than 65% is determined to be good, while the laminate giving a wear ratio of 65 % or more is determined to be unacceptable.

Furthermore, the epoxy resin composition can contain a different elastic component besides the above elastic component (D). For example, the different elastic component may be rubber fine particles without having a core-shell structure. The coefficient of thermal expansion of the cured product is decreased even more by using such rubber fine particles. Such rubber fine particles may be formed of acrylic rubber, silicone rubber, nitrile butadiene rubber, or the like. The particle size of the rubber fine particles is preferably within the range of 0.1 to 10 µm. The amount of the rubber fine particles in the epoxy resin composition is preferably within the range of 3 to 30 parts by weight based on 100 parts by weight of the epoxy resin (A) in the epoxy resin composition. When the particle size of the rubber fine particles is within the range, or when the content of rubber fine particles is contained in the epoxy resin composition, the rubber fine particles are dispersed effectively in the epoxy resin composition.

The epoxy resin composition is prepared by uniformly mixing the above components by use of a disperser, mixer, blender, or the like.

The epoxy resin composition is dissolved or dispersed into a solvent to from the resin varnish. The solvent may be methyl ethyl ketone, methoxypropanol, cyclohexanone, acetone, or the like. The solvent may be one selected among the above-listed compounds, or a combination thereof.

The prepreg of the present invention is manufactured by impregnating a substrate with the epoxy resin varnish and then forming semi-cured epoxy resin in the substrate by heating and drying. The substrate may be formed of glass cloth, aramid cloth, polyester cloth, glass nonwoven fabric, paper, or the like.

An explanation is specifically given as to preparation of the prepreg. First, the substrate is soaked in the resin varnish to be impregnated therewith. Next, the resin varnish in the substrate is heat-dried up to about 120 to 180 °C to remove the organic solvent from the resin varnish, for forming the prepreg by half-curing (B stage) of the epoxy resin composition.

The amount of impregnated epoxy resin composition in the prepreg is not particularly limited herein, but preferably in the range of 30 to 70 wt%.

A laminate is manufactured by stacking a predermined number of the prepregs together with a plurality of metal foils, and then heating and pressing the stacked prepregs at a predetermined heating temperature (e.g., 150 to 300 °C) and a predetermined pressure (e.g., 0.98 to 6.0 MPa) for a predetermined time (e.g., 10 to 240 minutes). In this process, the metal foil may be provided on one side or both sizes of the prepregs. The metal foil may be copper foil, aluminum foil, or the like. The thickness of the metal foil is generally set to be 3 to 105 µm, preferably 12 to 35 µm.

The surface of the metal foil of the laminate is formed thereon with a conductive pattern in an etching or the similar process, and then provided with a circuit to constitute a printed wiring board.

A detailed explanation is made as to the present invention, with reference to the following examples. The present invention is not limited by the following example.

### EXAMPLE

[1] The inventors prepared a laminate to be evaluated, in the following manufacturing process.

### (1) Composition Components

Resin varnishes with the composition ratios (parts by weight) shown in Table 1 were prepared. The abbreviations of the components in Table 1 are given as follows.

### <Epoxy resins>

EXA153: EPICLON epoxy resin available from DIC Corporation
YDB400: a brominated bisphenol-A epoxy resin available from Tohto Kasei Co., Ltd.
EPON1031: an epoxy resin available from HEXION Specialty Chemicals
DER593: an epoxy resin which is available from Dow Chemical Company and contains both nitrogen and bromine atoms in its molecule (also contains an oxazolidine ring); epoxy equivalents: 330 to 390 g/eq; bromine content: 17 to 18 wt%, approximately 2 epoxy groups per molecule on average.
N690: a cresol-novolac epoxy resin which is available from DIC Corporation and contains no nitrogen and bromine atoms in its molecule; epoxy equivalents: 190 to 240 g/eq; bromine content: 0 wt%; 6 to 4 epoxy groups per molecule on average; resin softening point: approximately 95°C.

### <Curing agent>

VH4170: a bisphenol-A novolac resin available from DIC Corporation, a bisphenol-A novolac curing agent, hydroxyl equivalents 118 g/eq, resin softening point: 105°C, content of bifunctional bisphenol-A: approximately 25%.

### <Inorganic filler>

Spherical silica: "SO-25R" available from Admatechs Co., Ltd., average particle size: 0.4 to 0.6 µm (spherical)
Aluminum hydroxide: "C-303" available from Sumitomo Chemical Co., Ltd., average particle size: approximately 4 µm

### <Curing accelerator>

IM1000: a trialkoxy silyl imidazole silane without having secondary hydroxyl groups which is available from Nikko Materials Co., Ltd.

### <Elastic component>

AC3816N: core-shell rubber particles comprising an acrylic resin in its core and a polymethacrylate resin in its shell, which is available from Ganz Chemical Company, Ltd.; low level of crosslinking in the core; structure with fusion between primary particles
AC3355: core-shell rubber particles comprising an acrylic resin in its core and a polymethacrylate resin in its shell, which is available from Ganz Chemical Company, Ltd.; structure free from fusion between primary particles
AC3832: core-shell rubber particles comprising an acrylic resin in its core and a polymethacrylate resin in its shell, which is available from Ganz Chemical Company, Ltd.; high level of crosslinking in the core; structure free from fusion between primary particles

### (2) Method of Preparing Resin Varnish

Each component shown in Table 1 (excluding the inorganic filler) and a solvent (a mixed solvent of methyl ethyl ketone:methoxypropanol:acetone = 2:1:2 by weight) were mixed in a mixing ratio shown in Table 1, and then stirred by use of a disperser to be uniformly mixed with each other. Next, an inorganic filler was added to the resultant mixture in a predetermined amount, and then stirred for an additional 1 hour by use of the disperser. Subsequently, the mixture were dispersed using a nanomill to form the resin varnish with solvent content of 25 to 40 wt% and solid content (other than solvent) of 60 to 75 wt%.

### (3) Manufacture of Prepreg

Glass cloth ("7628 Type Cloth" available from Nitto Boseki Co., Ltd.) was used as the substrate. The glass cloth was impregnated with the resin varnish at room temperature and then heated up to approximately 130 to 170 by use of a non-contact type heating unit. Thus, the solvent in the resin varnish was removed by drying and the epoxy resin composition was semi-cured to form a prepreg.

The resin content in this prepreg was controlled to be 106 resin parts by weight (47 wt% resin) to 100 parts by weight of glass cloth.

### (4) Fabrication of Laminate

Eight sheets of the prepreg (340 mm × 510 mm) prepared in the above procedures were sandwiched between the roughened surfaces of two sheets of copper foil (thickness 35 µm, JTC foil, available from Nikko Gould Foil Company, Ltd.), and a hot press treatment was carried out for 90 min under conditions of 180 °C and 30 kgf/cm² (2.9 MPa) to form a laminate.
[2] By using the following methods, the inventors evaluated the laminates manufactured in the above procedures, for coefficient of thermal expansion (α_{z}) in the direction of thickness (Z), drill bit wear, and dry-leaching of plating. The results are shown in Table 1.

### (1) Coefficient of Thermal Expansion (= CTE)

As to the laminates manufactured in the above procedures, the linear coefficient of thermal expansion (α_{z}) was measured in the thickness direction (Z) of the laminate at a temperature below the glass transition temperature (Tg) by use of TMA (Thermo-mechanical analysis), according to JIS C 6481.

### (2) Drill Bit Wear

Three sheets of the laminate each of which is manufactured in the above procedures and has a thickness of approximately 1.6 mm were subjected to a 5000 hit drilling process using a φ0.3 mm drill bit to form pass-through holes. The amount of drill bit wear was measured after this drilling process.

An NHUL020 drill bit available from Union Seal Ltd. was used. The rotation speed of the drill during drilling was set at 160 krpm, and the feed rate thereof was 3.2 m/min.

For each example, the drill bit wear rate is obtained through the above procedures, and designated as a double circle (less than 50%), a single circle (50% or more, and less than 65%), a triangle (65% or more, and less than 70%), "X" (70% or more, and less than 80%), or "XX" (80% or more).

### (3) Evaluation of Leaching of Plating Solution

After the above drilling process, through-hole plating is carried out at a thickness of 25 µm to form plated through-holes in the laminate. Then, the depth of leaching of the plating solution into the laminate from the inside walls of the through-holes was evaluated.

According to the evaluation shown in Table 1, it can clearly be seen by a comparison between examples 1 to 13 and comparative examples 1 to 4 that in the examples of the present invention, not only is the coefficient of thermal expansion (α_{z}) in the direction of thickness (Z) kept at 48 or lower, but the drilling workability and effectiveness in controlling leaching of the plating solution are also excellent.

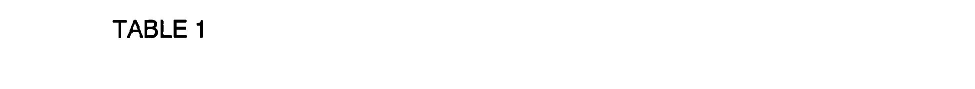

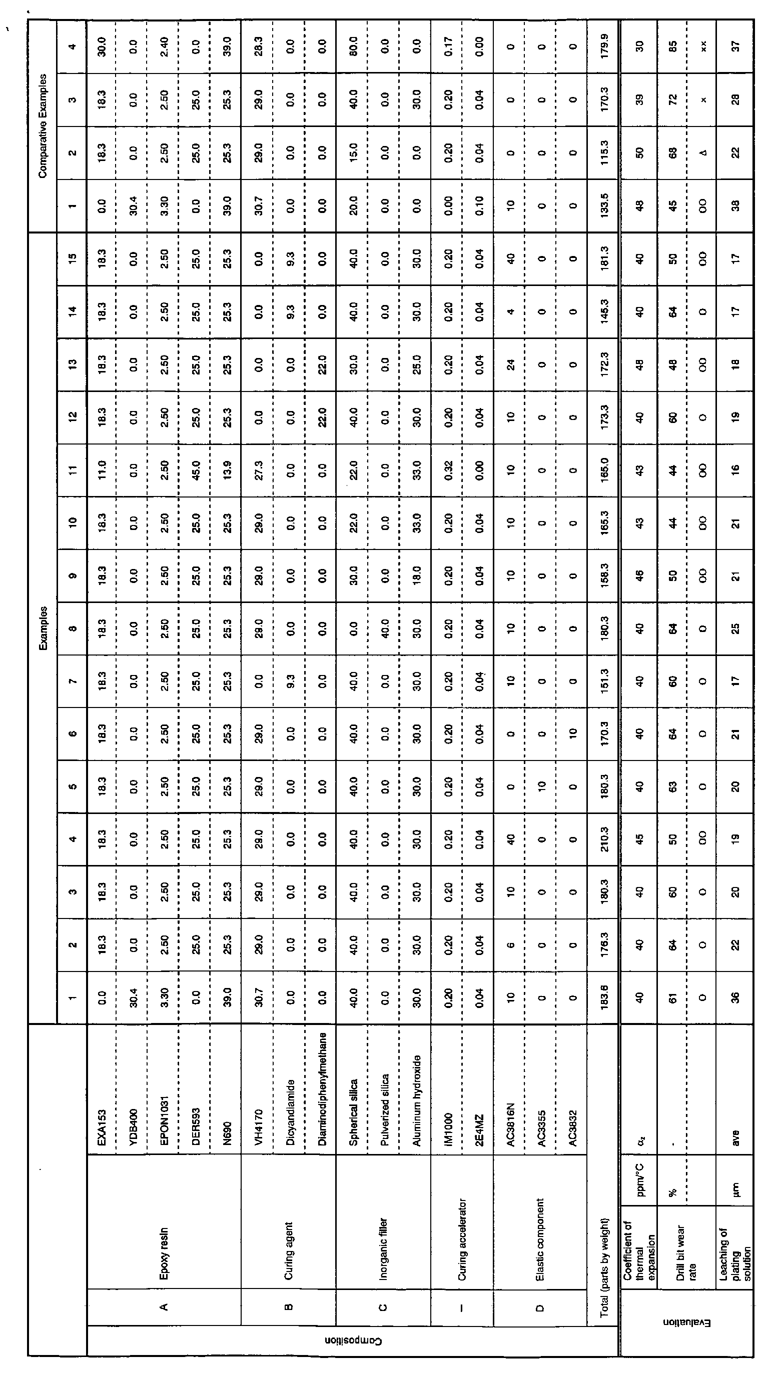

## Claims

1. An epoxy resin composition comprising:
(A) an epoxy resin;
(B) a curing agent composed of phenolic novolac resin curing agent or amine curing agent,
(C) an inorganic filler composed of aluminum hydroxide with or without spherical silica; and
(D) an elastic component made of minute particles having a core-shell structure with its shell constituted by a resin which is compatible with said epoxy resin (A),
wherein said epoxy resin composition exhibits, when cured into an article, a linear coefficient (az) of thermal expansion of 48 or less with respect to a thickness of said article.

2. An epoxy resin composition as set forth in claim 1, wherein
7 to 40 parts by weight of said elastic component (D) is incorporated with respect to 100 parts by weight of total of said epoxy resin (A) and said curing agent (B).

3. An epoxy resin composition as set forth in claim 1, wherein
said elastic component (D) has a structure free from fusion between its primary particles.

4. An epoxy resin composition as set forth in claim 1, wherein
said elastic component (D) has a structure with its primary particles being fused with each other.

5. An epoxy resin composition as set forth in claim 1, wherein
said curing agent (B) is phenolic novolac resin curing agent, and 60 or less parts by weight of said inorganic filler is incorporated with respect to 100 parts by weight of total of said epoxy resin (A) and said curing agent (B).

6. An epoxy resin composition as set forth in claim 1, wherein
said curing agent (B) is phenolic novolac resin curing agent, and
said inorganic filler (C) has 1 or less of a weight ratio of the spherical silica to aluminum hydroxide.

7. An epoxy resin composition as set forth in claim 1, wherein
said curing agent (B) is phenolic novolac resin curing agent,
said epoxy resin (A) includes an epoxy resin (A1) which has an oxazolidone ring within its molecular structure, and an epoxy equivalent of 30 to 390 g/eq, a bromine content of 10 to 20 % by weight.

8. An epoxy resin composition as set forth in claim 1, wherein
said curing agent (B) is dicyandiamide.

9. A prepreg fabricated by impregnating a substrate with said epoxy resin composition of claim 1 and half-curing the same by heat-drying.

10. A laminate fabricated by stacking a predetermined number of the prepregs of claim 9 together with a metal foil, and heating and pressing the same.

11. A printed wiring board having a conductor pattern on said metal foil of the laminate of claim 10.
